(19) Europäisches Patentamt
European Patent Office
Office européen des brevets

(11) **EP 3 107 214 A1**

(12) **EUROPEAN PATENT APPLICATION**
published in accordance with Art. 153(4) EPC

(43) Date of publication:
**21.12.2016 Bulletin 2016/51**

(51) Int Cl.:
***H03M 13/11*** *(2006.01)*

(21) Application number: **14882620.9**

(22) Date of filing: **04.09.2014**

(86) International application number:
**PCT/CN2014/085949**

(87) International publication number:
**WO 2015/120719 (20.08.2015 Gazette 2015/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.02.2014 CN 201410049187**

(71) Applicant: **ZTE Corporation**
**Shenzhen, Guangdong 518057 (CN)**

(72) Inventors:
• **LI, Liguang**
**Shenzhen**
**Guangdong 518057 (CN)**
• **XU, Jun**
**Shenzhen**
**Guangdong 518057 (CN)**
• **YUAN, Zhifeng**
**Shenzhen**
**Guangdong 518057 (CN)**
• **XU, Jin**
**Shenzhen**
**Guangdong 518057 (CN)**
• **TIAN, Kaibo**
**Shenzhen**
**Guangdong 518057 (CN)**

(74) Representative: **Novagraaf Technologies**
**Bâtiment O2**
**2, rue Sarah Bernhardt**
**CS90017**
**92665 Asnières-sur-Seine Cedex (FR)**

(54) **METHOD AND APPARATUS FOR PROCESSING INFORMATION**

(57) Provided are a method and apparatus for processing information. The apparatus includes: one or more memories, configured to store parameters of one basic parity check matrix set; and one or more processors, configured to encode information bits to be encoded or decode data to be decoded using the basic parity check matrix set $Hb$, wherein at least 50 percent of short loops-4 in a basic parity check matrix $Hb_{j1}$ among all basic parity check matrices in the basic parity check matrix set $Hb$ except $Hb_{j0}$ are the same as short loops-4 in the $Hb_{j0}$, where j0 is a fixed positive integer between 0 and L-1, L is the number of basic parity check matrices contained in the basic parity check matrix set, and $j1 = 0,1,...,j0 -1, j0 + 1,..., L -1$.

One or more memories
20

One or more processors
22

**Fig. 2**

**Description**

**Technical Field**

The present disclosure relates to the field of communications, and in particular to a method and apparatus for processing information.

**Background**

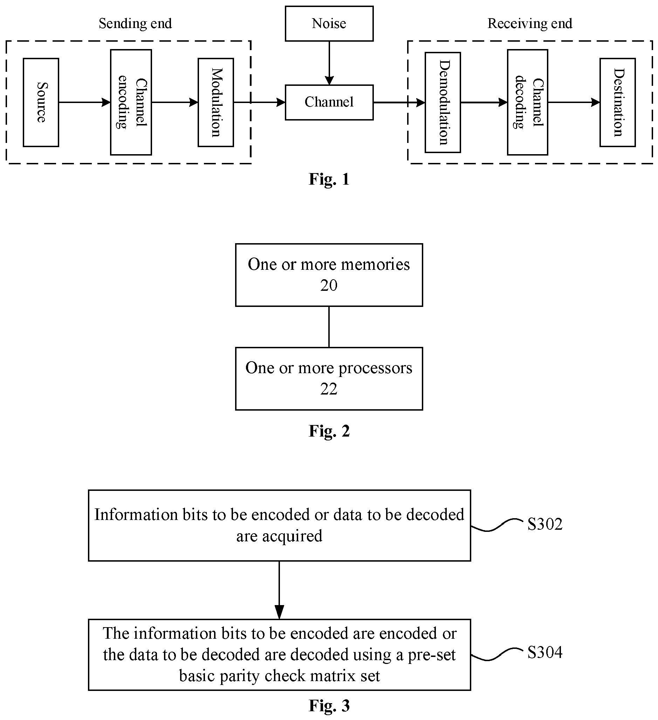

As shown in Fig. 1, currently, a digital communication system can be generally divided into three parts: a sending end, a channel and a receiving end. The sending end usually includes a source, a channel encoder, a modulator (or write-in unit) and other parts. The receiving end usually includes a demodulator (or read-out unit), a channel decoder and a destination. The channel (or storage medium) exists between the sending end and the receiving end, and a noise source exists in the channel. A channel encoding link (including channel encoding/decoding, modulation/demodulation and the like) is the key of an entire digital communication physical layer, which decides the efficiency and reliability of underlying transmission of the digital communication system.

A main function of the channel encoder is to fight against the influence on useful signals caused by various noises and interferences in the channel. By manually adding some pieces of redundant information, the system is enabled to have a capability of automatically correcting an error, thereby guaranteeing the reliability of information transmission. In the related art, there have already been multiple channel codes such as a Low Density Parity Check (LDPC) code, a turbo code, a convolution code and a Reed-Solomon (RS) code. Various experiments and theories have proven that the LDPC code is a channel code, having most excellent performances, under an Additive White Gaussian Noise (AWGN) channel, the performances approaching the Shannon limit. The LDPC code is a linear block code which can be defined by a low density parity check matrix or a bipartite graph, and low-complexity encoding and decoding can be achieved by utilizing the sparsity of the check matrix thereof, thereby making LDPC become practical.

From a perspective of performances, the performances of the LDPC code are excellent. However, from a perspective of hardware complexity, the hardware complexity of the LDPC code is very high due to the fact that LDPC decoding is an iterative decoding process. Moreover, the LDPC code is a linear block code, and therefore there is a lack of certain flexibility in design of code rates and code lengths. In an 802.16e standard, in order to provide certain flexibility in terms of the code lengths and the code rates, 19 code lengths are supported, four code rates (1/2, 2/3, 3/4 and 5/6) are supported, and it is needed to adopt six check matrices for implementation. In an 802.11ad standard, four check matrices are adopted, and an encoding solution for four fixed code lengths and different code rates is provided. In an 802.11 n/ac standard, 12 check matrices are adopted, and an encoding solution for four code rates and three code lengths is provided. For each one among the above standards, check matrices of a plurality of LDPC codes are needed to support the requirement on flexibility. Due to the fact that the check matrices corresponding to different code rates are not associated substantially, for a receiving decoding end, a plurality of decoders are needed to correspondingly decode each code rate or one decoder supporting the requirements of the multiple check matrices needs to be adopted. Regardless of which method is adopted, the hardware cost is high, and it is inconvenient to specifically optimize some units in the decoder.

An effective solution has not been proposed yet currently for the problems in the related art that an LDPC encoding/decoding system is high in hardware complexity and low in flexibility.

**Summary**

The embodiments of the present disclosure provide a method and apparatus for processing information, which are intended to at least solve the problems in the related art that an LDPC encoding/decoding system is high in hardware complexity and low in flexibility.

According to one aspect of the embodiments of the present disclosure, an apparatus for processing information is provided, which may include: one or more memories, configured to store parameters of one basic parity check matrix set; and one or more processors, configured to encode information bits to be encoded or decode data to be decoded using the basic parity check matrix set $Hb$, wherein at least 50 percent of short loops-4 in a basic parity check matrix $Hb_{j1}$ among all basic parity check matrices in the basic parity check matrix set $Hb$ except $Hb_{j0}$ are the same as short loops-4 in the $Hb_{j0}$, where j0 is a fixed positive integer between 0 and L-1, L is the number of basic parity check matrices contained in the basic parity check matrix set, and $j1 = 0,1,..., j0$ -1, $j0 + 1,..., L$ -1.

In an exemplary embodiment, a dimension of each basic parity check matrix in the basic parity check matrix set may be $Mb{\times}Nb$, the number of columns $Nb$ may be a fixed value $nb0$, the number of rows $Mb$ may be $mbi$, and each $mbi$ may correspond to one code rate $ri$, where $ri$ is a real number between 0 and 1, $i = 0,1,2,......, L-1$, $mbi$ is an integer greater than 0, and $nb0$ is an integer greater than 0.

In an exemplary embodiment, each of the short loops-4 may be constituted by four non-minus-one elements $[h_{ac}, h_{bc}, h_{bd}, h_{ad}]$ obtained by intersecting a $c^{th}$ column and a $d^{th}$ column with an $a^{th}$ row and a $b^{th}$ row in the basic parity check matrix, where a, b, c and d are any integers which are greater than or equal to 0 and are smaller than $nb0$, c<d, and a<b.

In an exemplary embodiment, a set $Scj1$ constituted by non-minus-one elements in a $c^{th}$ column in the basic parity check matrix $Hb_{j1}$, among all the basic parity check matrices in the basic parity check matrix set except the $Hb_{j0}$, from top to bottom may be a subset of a set $Scj0$ constituted by non-minus-one elements in a $c^{th}$ column of the $Hb_{j0}$ from top to bottom, where the $Hb_{j0}$ is a basic parity check matrix of which the number of matrix rows is equal to a maximum column weight $MaxW$, the maximum column weight $MaxW$ refers to a column weight of a column with maximum weight among all columns of all basic parity check matrices in the basic parity check matrix set, $MaxW$ is a positive integer, and c is an integer which is greater than or equal to 0 and is smaller than $nb0$.

In an exemplary embodiment, a top-to-bottom sequence of all elements in the set $Scj1$ may be identical to a top-to-bottom sequence of these elements in the set $Scj0$.

In an exemplary embodiment, each basic parity check matrix $Hbi$ in the basic parity check matrix set may be equal to [$Abi$ $Bbi$], where a matrix $Abi$ is a system bit part matrix with a dimension of $Mb \times (Nb - Mb)$, a matrix $Bbi$ is a check bit part matrix with a dimension of $Mb \times Mb$, the number of rows of the matrix $Abi$ is equal to the number of rows of the matrix $Bbi$, row weights of the matrices $Abi$ and $Bbi$ are greater than or equal to 1, and the matrix $Bbi$ is a strictly lower triangular structure matrix or a double diagonal structure matrix.

In an exemplary embodiment, the number of minus-one elements on different rows of the system bit part matrix of each basic parity check matrix in the basic parity check matrix set may be equal or has a difference smaller than or equal to 2.

In an exemplary embodiment, more than two or three continuous minus-one elements may not exist on each column of the system bit part matrix of each basic parity check matrix in the basic parity check matrix set.

In an exemplary embodiment, more than two or three continuous minus-one elements may not exist on each row of the system bit part matrix in the basic parity check matrix set.

In an exemplary embodiment, the value of $nb0$ may include: 8, 16, 24, 32, 40 or 48.

In an exemplary embodiment, the condition that the short loops-4 in the $Hb_{j1}$ are the same as the short loops-4 in the $Hb_{j0}$ may include that: values of all corresponding elements of the short loops-4 in the $Hb_{j1}$, and the short loops-4 in the $Hb_{j0}$ are equal, two elements of each short loop-4 on a row of the $Hb_{j1}$, are equal to two elements of each short loop-4 on a row of the $Hb_{j0}$ in a one-to-one correspondence manner, and two elements of each short loop-4 on a column of the $Hb_{j1}$, are equal to two elements of each short loop-4 on a column of the $Hb_{j0}$ in a one-to-one correspondence manner.

In an exemplary embodiment, any four elements $[h_{ac}, h_{bc}, h_{bd}, h_{ad}]$ which are able to constitute a loop-4 in each basic parity check matrix of the basic parity check matrix set may satisfy an inequality $(h_{ac}-h_{bc}+h_{bd}-h_{ad})\%zf \neq 0$, where % is a modulo operator, zf is an expansion factor, a, b, c and d are any integers which are greater than or equal to 0 and are smaller than $nb0$, $a \neq b$, and $c \neq d$.

In an exemplary embodiment, the number of any six elements $\llcorner h_{ai}, h_{bi}, h_{bj}, h_{cj}, h_{ck}, h_{ak}\lrcorner$ which are able to constitute a loop-6 in all basic parity check matrices of the basic parity check matrix set and satisfy an inequality $(h_{ai}-h_{bi}+h_{bj}-h_{cj}+h_{ck}-h_{ak})\%zf ==0$ may be minimum, where % is a modulo operator, $zf$ is an expansion factor, a, b, c, i, j and k are any integers which are greater than or equal to 0 and are smaller than $nb0$, $a \neq b \neq c$, and $i \neq j \neq k$.

In an exemplary embodiment, a basic parity check matrix of which the number of matrix rows, j, is smaller than a maximum column weight $MaxW$ in the basic parity check matrix set may be equal to a matrix constituted by last j rows of the $Hb_{j0}$, where the $Hb_{j0}$ is a basic parity check matrix of which the number of matrix rows is equal to the maximum column weight $MaxW$, and $MaxW$ and j are positive integers.

In an exemplary embodiment, one or more elements among any four elements $[h_{ai}, h_{bi}, h_{bj}, h_{aj}]$ constituting a loop-4 in all basic parity check matrices of the basic parity check matrix set may belong to elements of which column weights are 2, and may satisfy an inequality $(h_{ai}-h_{bi}+h_{bj}-h_{aj})\%zf \neq 0$; and one or more elements among any six elements $\llcorner h_{ai}, h_{bi}, h_{bj}, h_{cj}, h_{ck}, h_{ak}\lrcorner$ constituting a short loop-6 in all basic parity check matrices of the basic parity check matrix set may belong to elements of which column weights are 2, and may satisfy an inequality $(h_{ai} - h_{bi} + h_{bj} -h_{cj} +h_{ck}-h_{ak})\%zf \neq 0$, where % is a modulo operator, $zf$ is an expansion factor, a, b, c, i, j and k are any integers which are greater than or equal to 0 and are smaller than $nb0$, $a \neq b \neq c$, and $i \neq j \neq k$.

In an exemplary embodiment, the value of $ri$ is [1/2, 5/8, 3/4, 13/16], i=0, 1, 2, 3, any four elements $[h_{ai}, h_{bi}, h_{bj}, h_{aj}]$ constituting a loop-4 in a basic parity check matrix Hb0 of which a corresponding code rate r0=1/2 may all satisfy an inequality $(h_{ai}-h_{bi}+h_{bj}-h_{aj})\%zf \neq 0$; and any six elements $\llcorner h_{ai}, h_{bi}, h_{bj}, h_{cj}, h_{ck}, h_{ak}\lrcorner$ constituting a short loop-6 in the basic parity check matrix Hb0 may all satisfy an inequality $(h_{ai} - h_{bi} + h_{bj} -h_{cj} +h_{ck}-h_{ak})\%zf \neq 0$, where % is a modulo operator, $zf$ is an expansion factor, a, b, c, i, j and k are any integers which are greater than or equal to 0 and are smaller than $nb0$, $a \neq b \neq c$, and $i \neq j \neq k$.

In an exemplary embodiment, the one or more processors may encode the information bits to be encoded or decode the data to be decoded by means of the following modes: determining a block of the information bits to be encoded or a block of the data to be decoded, selecting a basic parity check matrix from the basic parity check matrix set according to the block of the information bits to be encoded or the block of the data to be decoded, and encoding the block of the information bits to be encoded or decoding the block of the data to be decoded based on the selected basic parity check matrix.

According to another aspect of the embodiments of the present disclosure, a method for processing information is provided, which may include that: information bits to be encoded or data to be decoded are acquired; and the information bits to be encoded are encoded or the data to be decoded are decoded using a pre-set basic parity check matrix set $Hb$, wherein at least 50 percent of short loops-4 in a basic parity check matrix $Hb_{j1}$ among all basic parity check matrices in the basic parity check matrix set $Hb$ except $Hb_{j0}$ are the same as short loops-4 in the $Hb_{j0}$, where j0 is a fixed positive integer between 0 and L-1, L is the number of basic parity check matrices contained in the basic parity check matrix set, and $j1 = 0,1,..., j0 -1, j0 + 1,..., L -1$.

In an exemplary embodiment, a dimension of each basic parity check matrix in the basic parity check matrix set may be $Mb \times Nb$, the number of columns $Nb$ may be a fixed value $nb0$, the number of rows $Mb$ may be $mbi$, and each $mbi$ may correspond to one code rate $ri$, where $ri$ is a real number greater than 0, $i = 0,1,2,......, L -1$, $mbi$ is an integer greater than 0, and $nb0$ is an integer greater than 0.

In an exemplary embodiment, each of the short loops-4 may be constituted by four non-minus-one elements $[h_{ac},h_{bc},h_{bd},h_{ad}]$ obtained by intersecting a c$^{th}$ column and a d$^{th}$ column with an a$^{th}$ row and a b$^{th}$ row in the basic parity check matrix, where a, b, c and d are any integers which are greater than or equal to 0 and are smaller than $nb0$, c<d, and a<b.

In an exemplary embodiment, a set $Scj1$ constituted by non-minus-one elements in a c$^{th}$ column in the basic parity check matrix $Hb_{j1}$, among all the basic parity check matrices in the basic parity check matrix set except the $Hb_{j0}$, from top to bottom may be a subset of a set $Scj0$ constituted by non-minus-one elements in a c$^{th}$ column of the $Hb_{j0}$ from top to bottom, where the $Hb_{j0}$ is a basic parity check matrix of which the number of matrix rows is equal to a maximum column weight $MaxW$, the maximum column weight $MaxW$ refers to a column weight of a column with maximum weight among all columns of all basic parity check matrices in the basic parity check matrix set, $MaxW$ is a positive integer, and c is an integer which is greater than or equal to 0 and is smaller than $nb0$.

In an exemplary embodiment, a top-to-bottom sequence of all elements in the set $Scj1$ may be identical to a top-to-bottom sequence of these elements in the set $Scj0$.

In an exemplary embodiment, each basic parity check matrix $Hbi$ in the basic parity check matrix set may be equal to [$Abi$ $Bbi$], where a matrix $Abi$ is a system bit part matrix with a dimension of $Mb \times (Nb -Mb)$, a matrix $Bbi$ is a check bit part matrix with a dimension of $Mb \times Mb$, the number of rows of the matrix $Abi$ is equal to the number of rows of the matrix $Bbi$, row weights of the matrices $Abi$ and $Bbi$ are greater than or equal to 1, and the matrix $Bbi$ is a strictly lower triangular structure matrix or a double diagonal structure matrix.

In an exemplary embodiment, the number of minus-one elements on different rows of the system bit part matrix of each basic parity check matrix in the basic parity check matrix set may be equal or has a difference smaller than or equal to 2.

In an exemplary embodiment, more than two or three continuous minus-one elements may not exist on each column of the system bit part matrix of each basic parity check matrix in the basic parity check matrix set.

In an exemplary embodiment, more than two or three continuous minus-one elements may not exist on each row of the system bit part matrix in the basic parity check matrix set.

In an exemplary embodiment, the value of $nb0$ may include: 8, 16, 24, 32, 40 or 48.

In an exemplary embodiment, the condition that the short loops-4 in the $Hb_{j1}$ are the same as the short loops-4 in the $Hb_{j0}$ may include that: values of all corresponding elements of the short loops-4 in the $Hb_{j1}$ and the short loops-4 in the $Hb_{j0}$ are equal, two elements of each short loop-4 on a row of the $Hb_{j1}$ are equal to two elements of each short loop-4 on a row of the $Hb_{j0}$ in a one-to-one correspondence manner, and two elements of each short loop-4 on a column of the $Hb_{j1}$ are equal to two elements of each short loop-4 on a column of the $Hb_{j0}$ in a one-to-one correspondence manner.

In an exemplary embodiment, any four elements $[h_{ac},h_{bc},h_{bd},h_{ad}]$ which are able to constitute a loop-4 in each basic parity check matrix of the basic parity check matrix set may satisfy an inequality $(h_{ac}-h_{bc}+h_{bd}-h_{ad})\%zf \neq 0$, where % is a modulo operator, zf is an expansion factor, a, b, c and d are any integers which are greater than or equal to 0 and are smaller than $nb0$, $a \neq b$, and $c \neq d$.

In an exemplary embodiment, the number of any six elements $[h_{ai},h_{bi},h_{bj},h_{cj},h_{ck},h_{ak}]$ which are able to constitute a loop-6 in all basic parity check matrices of the basic parity check matrix set and satisfy an inequality $(h_{ai} - h_{bi} + h_{bj} -h_{cj} + h_{ck} - h_{ak})\%zf ==0$ may be minimum, where % is a modulo operator, zf is an expansion factor, a, b, c, i, j and k are any integers which are greater than or equal to 0 and are smaller than $nb0$, $a \neq b \neq c$, and $i \neq j \neq k$.

In an exemplary embodiment, a basic parity check matrix of which the number of matrix rows, j, is smaller than a maximum column weight $MaxW$ in the basic parity check matrix set may be equal to a matrix constituted by last j rows of the $Hb_{j0}$, where the $Hb_{j0}$ is a basic parity check matrix of which the number of matrix rows is equal to the maximum column weight $MaxW$, and $MaxW$ and j are positive integers.

In an exemplary embodiment, one or more elements among any four elements $[h_{ai},h_{bi},h_{bj},h_{aj}]$ constituting a loop-4 in all basic parity check matrices of the basic parity check matrix set may belong to elements of which column weights are 2, and may satisfy an inequality $(h_{ai}-h_{bi}+h_{bj}-h_{aj})\%zf \neq 0$; and one or more elements among any six elements $\llcorner h_{ai},h_{bi},h_{bj},h_{cj},h_{ck},h_{ak}\lrcorner$ constituting a short loop-6 in all basic parity check matrices of the basic parity check matrix set may belong to elements of which column weights are 2, and may satisfy an inequality $(h_{ai}-h_{bi}+h_{bj}-h_{cj}+h_{ck}-h_{ak})\%zf \neq 0$, where % is a modulo operator, zf is an expansion factor, a, b, c, i, j and k are any integers which are greater than or equal to 0 and are smaller than $nb0$, $a \neq b \neq c$, and $i \neq j \neq k$.

In an exemplary embodiment, the value of $ri$ is [1/2, 5/8, 3/4, 13/16], i=0, 1, 2, 3, any four elements $[h_{ai},h_{bi},h_{bj},h_{aj}]$ constituting a loop-4 in a basic parity check matrix Hb0 of which a corresponding code rate r0=1/2 may all satisfy an inequality $(h_{ai}-h_{bi}+h_{bj}-h_{aj})\%zf \neq 0$; and any six elements $\llcorner h_{ai},h_{bi},h_{bj},h_{cj},h_{ck},h_{ak}\lrcorner$ constituting a short loop-6 in the basic parity check matrix Hb0 may all satisfy an inequality $(h_{ai} - h_{bi} +_{bj})-h_{cj}+h_{ck} -h_{ak})\%zf \neq 0$, where % is a modulo operator, zf is an expansion factor, a, b, c, i, j and k are any integers which are greater than or equal to 0 and are smaller than $nb0$, $a \neq b \neq c$, and $i \neq j \neq k$.

In an exemplary embodiment, the step that the information bits to be encoded are encoded or the data to be decoded are decoded using the pre-set basic parity check matrix set *Hb* may include that: a block of the information bits to be encoded or a block of the data to be decoded is determined, a basic parity check matrix is selected from the basic parity check matrix set according to the block of the information bits to be encoded or the block of the data to be decoded, and the block of the information bits to be encoded are encoded or the block of the data to be decoded are decoded based on the selected basic parity check matrix.

By means of the embodiments of the present disclosure, when LDPC encoding/decoding is adopted, a plurality of check matrices corresponding to a plurality of code rates are associated, so that encoding or decoding operation can be performed using the same encoder or decoder, the problems of high hardware complexity and low flexibility are solved, the hardware complexity is reduced, and the flexibility in encoding/decoding operation is improved.

## Brief Description of the Drawings

The drawings illustrated herein are intended to provide further understanding of the present disclosure, and constitute a part of the present disclosure. The schematic embodiments and illustrations of the present disclosure are intended to explain the present disclosure, and do not form improper limits to the present disclosure. In the drawings:

Fig. 1 is a structural diagram of a digital communication system according to the related art;
Fig. 2 is a structural diagram of an apparatus for processing information according to an embodiment of the present disclosure;
Fig. 3 is a block diagram of a simple communication link model in an embodiment of the present disclosure;
Fig. 4 is a block diagram related to encoding of an LDPC code according to an embodiment of the present disclosure;
Fig. 5 is a block diagram related to decoding of an LDPC code according to an embodiment of the present disclosure;
Fig. 6 is a flowchart of a method for processing information according to an embodiment of the present disclosure;
Fig. 7 is a flowchart related to encoding of an LDPC code according to an embodiment of the present disclosure;
Fig. 8 is a flowchart related to decoding of an LDPC code according to an embodiment of the present disclosure;
Fig. 9 shows a structure of a basic parity check matrix of an LDPC code according to an embodiment of the present disclosure;
Fig. 10 is a diagram illustrating occurrence of loop-4 in a bipartite graph of an LDPC code in an embodiment of the present disclosure;
Fig. 11 is a diagram illustrating occurrence of loop-6 in a bipartite graph of an LDPC code in an embodiment of the present disclosure;
Fig. 12 is a diagram illustrating occurrence of loop-4 in a basic parity check matrix of an LDPC code in an embodiment of the present disclosure;
Fig. 13 is a diagram illustrating occurrence of loop-6 in a basic parity check matrix of an LDPC code in an embodiment of the present disclosure; and
Fig. 14 is a diagram of an expansion check matrix of an LDPC uniquely determined by a basic matrix, an expansion factor and a permutation matrix in an embodiment of the present disclosure.

## Detailed Description of the Embodiments

The present disclosure will be illustrated below with reference to the drawings and the embodiments in detail. It is important to note that the embodiments of the present disclosure and the characteristics in the embodiments can be mutually combined under the condition of no conflicts.

According to an embodiment of the present disclosure, an apparatus for processing information is provided.

Fig. 2 is a structural diagram of an apparatus for processing information according to an embodiment of the present disclosure. As shown in Fig. 2, the apparatus for processing information according to the embodiment of the present disclosure mainly includes: one or more memories 20, configured to store parameters of one basic parity check matrix set; and one or more processors 22, configured to encode information bits to be encoded or decode data to be decoded using the basic parity check matrix set $Hb$, wherein at least 50 percent of short loops-4 in a basic parity check matrix $Hb_{j1}$ among all basic parity check matrices in the basic parity check matrix set $Hb$ except $Hb_{j0}$ are the same as short loops-4 in the $Hb_{j0}$, where j0 is a fixed positive integer between 0 and L-1, L is the number of basic parity check matrices contained in the basic parity check matrix set, and $j1 = 0,1,..., j0 -1, j0 + 1,..., L -1$.

In an optional implementation of the embodiment of the present disclosure, a dimension of each basic parity check matrix in the basic parity check matrix set is $Mb \times Nb$, the number of columns $Nb$ is a fixed value $nb0$, the number of rows $Mb$ is $mbi$, and each $mbi$ corresponds to one code rate $ri$, where $ri$ is a real number between 0 and 1, $i = 0,1,2,......, L -1$, mbi is an integer greater than 0, and $nb0$ is an integer greater than 0.

In an optional implementation of the embodiment of the present disclosure, each of the short loops-4 is constituted by four non-minus-one elements $[h_{ac},h_{bc},h_{bd},h_{ad}]$ obtained by intersecting a $c^{th}$ column and a $d^{th}$ column with an $a^{th}$ row and a $b^{th}$ row in the basic parity check matrix, where a, b, c and d are any integers which are greater than or equal to 0 and are smaller than $nb0$, c<d, and a<b.

In an optional implementation of the embodiment of the present disclosure, a set $Scj1$ constituted by non-minus-one elements in a $c^{th}$ column in the basic parity check matrix $Hb_{j1}$, among all the basic parity check matrices in the basic parity check matrix set except the $Hb_{j0}$, from top to bottom is a subset of a set $Scj0$ constituted by non-minus-one elements in a $c^{th}$ column of the $Hb_{j0}$ from top to bottom, where the $Hb_{j0}$ is a basic parity check matrix of which the number of matrix rows is equal to a maximum column weight $MaxW$, the maximum column weight $MaxW$ refers to a column weight of a column with maximum weight among all columns of all basic parity check matrices in the basic parity check matrix set, j0 is an integer between 0 and L-1, $MaxW$ is a positive integer, and c is an integer which is greater than or equal to 0 and is smaller than $nb0$. In the embodiments, the column weight refers to the number of non-minus-one elements in a column in a basic check matrix.

In an optional implementation of the embodiment of the present disclosure, a top-to-bottom sequence of all elements in the set $Scj1$ is identical to a top-to-bottom sequence of these elements in the set $Scj0$.

In an optional implementation of the embodiment of the present disclosure, each basic parity check matrix $Hbi$ in the basic parity check matrix set is equal to $[Abi \ Bbi]$, where a matrix $Abi$ is a system bit part matrix with a dimension of $Mb \times (Nb -Mb)$, a matrix $Bbi$ is a check bit part matrix with a dimension of $Mb \times Mb$, the number of rows of the matrix $Abi$ is equal to the number of rows of the matrix $Bbi$, row weights of the matrices $Abi$ and $Bbi$ are greater than or equal to 1, and the matrix $Bbi$ is a strictly lower triangular structure matrix or a double diagonal structure matrix.

In an optional implementation of the embodiment of the present disclosure, the number of minus-one elements on different rows of the system bit part matrix of each basic parity check matrix in the basic parity check matrix set is equal or has a difference smaller than or equal to 2.

In an optional implementation of the embodiment of the present disclosure, more than two or three continuous minus-one elements do not exist on each column of the system bit part matrix of each basic parity check matrix in the basic parity check matrix set.

In an optional implementation of the embodiment of the present disclosure, more than two or three continuous minus-one elements do not exist on each row of the system bit part matrix in the basic parity check matrix set.

In an optional implementation of the embodiment of the present disclosure, the value of $nb0$ includes, but is not limited to, 8, 16, 24, 32, 40 or 48.

In an optional implementation of the embodiment of the present disclosure, the condition that the short loops-4 in the $Hb_{j1}$ are the same as the short loops-4 in the $Hb_{j0}$ includes that: values of all corresponding elements of the short loops-4 in the $Hb_{j1}$ and the short loops-4 in the $Hb_{j0}$ are equal, two elements of each short loop-4 on a row of the $Hb_{j1}$ are equal to two elements of each short loop-4 on a row of the $Hb_{j0}$ in a one-to-one correspondence manner, and two elements of each short loop-4 on a column of the $Hb_{j1}$ are equal to two elements of each short loop-4 on a column of the $Hb_{j0}$ in a one-to-one correspondence manner. That is, four elements of each short loop-4 in the matrix $Hb_{j1}$, are equal to four elements of each short loop-4 in the matrix $Hb_{j0}$; two elements of each short loop-4 on a row in the $Hb_{j1}$, are also on a row in the $Hb_{j0}$; and two elements of each short loop-4 on a column in the $Hb_{j1}$, are also on a column in the $Hb_{j0}$.

In an optional implementation of the embodiment of the present disclosure, any four elements $[h_{ac},h_{bc},h_{bd},h_{ad}]$ which are able to constitute a loop-4 in each basic parity check matrix of the basic parity check matrix set satisfy an inequality $(h_{ac}-h_{bc}+h_{bd}-h_{ad})\%zf \neq 0$, where % is a modulo operator, zf is an expansion factor, a, b, c and d are any integers which are greater than or equal to 0 and are smaller than $nb0$, $a \neq b$, and $c \neq d$. In this embodiment, the expansion factor $zf$ is a dimension of a permutation matrix (general unit matrix), and the value of zf should be greater than 0.

In an optional implementation of the embodiment of the present disclosure, the number of any six elements $[h_{ai},h_{bi},h_{bj},h_{cj},h_{ck},h_{ak}]$ which are able to constitute a loop-6 in all basic parity check matrices of the basic parity check matrix set and satisfy an inequality $(h_{ai} - h_{bi} +h_{bj}-h_{cj}+ h_{ck} - h_{ak})\%zf ==0$ is minimum, where % is a modulo operator, zf

is an expansion factor, a, b, c, i, j and k are any integers which are greater than or equal to 0 and are smaller than $nb0$, $a \neq b \neq c$, and $i \neq j \neq k$.

In an optional implementation of the embodiment of the present disclosure, a basic parity check matrix of which the number of matrix rows, j, is smaller than a maximum column weight $MaxW$ in the basic parity check matrix set is equal to a matrix constituted by last j rows of the $Hb_{j0}$, where the $Hb_{j0}$ is a basic parity check matrix of which the number of matrix rows is equal to the maximum column weight $MaxW$, and $MaxW$ and j are positive integers.

In an optional implementation of the embodiment of the present disclosure, one or more elements among any four elements $[h_{ai}, h_{bi}, h_{bj}, h_{aj}]$ in all basic parity check matrices of the basic parity check matrix set belong to elements of which column weights are 2, and satisfy an inequality $(h_{ai} - h_{bi} + h_{bj} - h_{aj})\%zf \neq 0$ ; and one or more elements among any six elements $[h_{ai}, h_{bi}, h_{bj}, h_{cj}, h_{ck}, h_{ak}]$ constituting a short loop-6 in all basic parity check matrices of the basic parity check matrix set belong to elements of which column weights are 2, and satisfy an inequality $(h_{ai} - h_{bi} + h_{bj} - h_{cj} + h_{ck} - h_{ak})\%zf \neq 0$, where % is a modulo operator, $zf$ is an expansion factor, a, b, c, i, j and k are any integers which are greater than or equal to 0 and are smaller than $nb0$, $a \neq b \neq c$, and $i \neq j \neq k$.

In an optional implementation of the embodiment of the present disclosure, the value of $ri$ is [1/2, 5/8, 3/4, 13/16], i=0, 1, 2, 3, any four elements $[h_{ai}, h_{bi}, h_{bj}, h_{aj}]$ constituting a loop-4 in a basic parity check matrix Hb0 of which a corresponding code rate r0=1/2 all satisfy an inequality $(h_{ai} - h_{bi} + h_{bj} - h_{aj})\%zf \neq 0$; and any six elements $[h_{ai}, h_{bi}, h_{bj}, h_{cj}, h_{ck}, h_{ak}]$ constituting a short loop-6 in the basic parity check matrix Hb0 all satisfy an inequality $(h_{ai} - h_{bi} + h_{bj} - h_{cj} + h_{ck} - h_{ak})\%zf \neq 0$, where % is a modulo operator, zf is an expansion factor, a, b, c, i, j and k are any integers which are greater than or equal to 0 and are smaller than $nb0$, $a \neq b \neq c$, and $i \neq j \neq k$.

In an optional implementation of the embodiment of the present disclosure, the one or more processors encode the information bits to be encoded or decode the data to be decoded by means of the following modes: determining a block of the information bits to be encoded or a block of the data to be decoded, selecting a basic parity check matrix from the basic parity check matrix set according to the block of the information bits to be encoded or the block of the data to be decoded, and encoding the block of the information bits to be encoded or decoding the block of the data to be decoded based on the selected basic parity check matrix.

By means of the above apparatus for processing information provided by the embodiments of the present disclosure, code rates which can be supported by an LDPC code are Ro, $R_1$, ..., $R_{L-1}$, corresponding basic parity check matrices are Hb$_0$, Hb$_1$, ..., Hb$_{(L-1)}$, the number of rows of the basic parity check matrices is respectively $M_0$, $M_1$, ..., $M_{L-1}$, the number of columns for each of the basic parity check matrices is $Nb$, L is the number of code rates to be constructed, and each basic parity check matrix is configured, so that encoding or decoding operation can be performed using the same encoder or decoder, the problems of high hardware complexity and low flexibility are solved, the hardware complexity is reduced, and the flexibility in encoding/decoding operation is improved.

According to an embodiment of the present disclosure, a method for processing information is provided, which may be implemented by means of the above apparatus for processing information.

Fig. 3 is a flowchart of a method for processing information according to an embodiment of the present disclosure. As shown in Fig. 3, the method mainly includes Step S302 to Step S304 as follows.

Step S302: Information bits to be encoded or data to be decoded are acquired.

Step S304: The information bits to be encoded are encoded or the data to be decoded are decoded using a pre-set basic parity check matrix set $Hb$ , wherein at least 50 percent of short loops-4 in a basic parity check matrix $Hb_{j1}$ among all basic parity check matrices in the basic parity check matrix set $Hb$ except $Hb_{j0}$ are the same as short loops-4 in the $Hb_{j0}$, where j0 is a fixed positive integer between 0 and L-1, L is the number of basic parity check matrices contained in the basic parity check matrix set, and $j1 = 0,1,..., j0 -1, j0 + 1,..., L -1$.

In an optional implementation solution, a dimension of each basic parity check matrix in the basic parity check matrix set is $Mb \times Nb$, the number of columns $Nb$ is a fixed value $nb0$, the number of rows $Mb$ is $mbi$ , and each $mbi$ corresponds to one code rate $ri$ , where $ri$ is a real number greater than 0, $i = 0,1,2,......, L -1$, mbi is an integer greater than 0, and $nb0$ is an integer greater than 0.

In the optional implementation solution, each of the short loops-4 is constituted by four non-minus-one elements $[h_{ac}, h_{bc}, h_{bd}, h_{ad}]$ obtained by intersecting a c$^{th}$ column and a d$^{th}$ column with an a$^{th}$ row and a b$^{th}$ row in the basic parity check matrix, where a, b, c and d are any integers which are greater than or equal to 0 and are smaller than $nb0$, c<d, and a<b.

In an optional implementation solution, a set $Scj1$ constituted by non-minus-one elements in a c$^{th}$ column in the basic parity check matrix $Hb_{j1}$, among all the basic parity check matrices in the basic parity check matrix set except the $Hb_{j0}$, from top to bottom is a subset of a set $Scj0$ constituted by non-minus-one elements in a c$^{th}$ column of the $Hb_{j0}$ from top to bottom, where the $Hb_{j0}$ is a basic parity check matrix of which the number of matrix rows is equal to a maximum column weight $MaxW$, the maximum column weight $MaxW$ refers to a column weight of a column with maximum weight among all columns of all basic parity check matrices in the basic parity check matrix set, $MaxW$ is a positive integer, and c is an integer which is greater than or equal to 0 and is smaller than $nb0$.

In an optional implementation solution, a top-to-bottom sequence of all elements in the set $Scj1$ is identical to

a top-to-bottom sequence of these elements in the set *Scj*0.

In an optional implementation solution, each basic parity check matrix *Hbi* in the basic parity check matrix set is equal to [*Abi Bbi*], where a matrix *Abi* is a system bit part matrix with a dimension of $Mb \times (Nb - Mb)$, a matrix *Bbi* is a check bit part matrix with a dimension of $Mb \times Mb$, the number of rows of the matrix *Abi* is equal to the number of rows of the matrix *Bbi,* row weights of the matrices *Abi* and *Bbi* are greater than or equal to 1, and the matrix *Bbi* is a strictly lower triangular structure matrix or a double diagonal structure matrix.

In an optional implementation solution, the number of minus-one elements on different rows of the system bit part matrix of each basic parity check matrix in the basic parity check matrix set is equal or has a difference smaller than or equal to 2.

In an optional implementation solution, more than two or three continuous minus-one elements do not exist on each column of the system bit part matrix of each basic parity check matrix in the basic parity check matrix set.

In an optional implementation solution, more than two or three continuous minus-one elements do not exist on each row of the system bit part matrix in the basic parity check matrix set.

In an optional implementation solution, the value of *nb*0 includes, but is not limited to, 8, 16, 24, 32, 40 or 48.

In an optional implementation solution, the condition that the short loops-4 in the $Hb_{j1}$ are the same as the short loops-4 in the $Hb_{j0}$ includes that: values of all corresponding elements of the short loops-4 in the $Hb_{j1}$ and the short loops-4 in the $Hb_{j0}$ are equal, two elements of each short loop-4 on a row of the $Hb_{j1}$ are equal to two elements of each short loop-4 on a row of the $Hb_{j0}$ in a one-to-one correspondence manner, and two elements of each short loop-4 on a column of the $Hb_{j1}$ are equal to two elements of each short loop-4 on a column of the $Hb_{j0}$ in a one-to-one correspondence manner.

In an optional implementation solution, any four elements [$h_{ac},h_{bc},h_{bd},h_{ad}$] which are able to constitute a loop-4 in each basic parity check matrix of the basic parity check matrix set satisfy an inequality $(h_{ac}-h_{bc}+h_{bd}-h_{ad})\%zf \neq 0$, where % is a modulo operator, zf is an expansion factor, a, b, c and d are any integers which are greater than or equal to 0 and are smaller than *nb*0, $a \neq b$, and $c \neq d$.

In an optional implementation solution, the number of any six elements ⌊$h_{ai},h_{bi},h_{bj},h_{cj},h_{ck},h_{ak}$⌋ which are able to constitute a loop-6 in all basic parity check matrices of the basic parity check matrix set and satisfy an inequality $(h_{ai} - h_{bi} +h_{bj}-h_{cj}+ h_{ck} - h_{ak})\%zf ==0$ is minimum, where % is a modulo operator, zf is an expansion factor, a, b, c, i, j and k are any integers which are greater than or equal to 0 and are smaller than *nb*0, $a \neq b \neq c$, and $i \neq j \neq k$.

In an optional implementation solution, a basic parity check matrix of which the number of matrix rows, j, is smaller than a maximum column weight *MaxW* in the basic parity check matrix set is equal to a matrix constituted by last j rows of the $Hb_{j0}$, where the $Hb_{j0}$ is a basic parity check matrix of which the number of matrix rows is equal to the maximum column weight *MaxW,* and *MaxW* and j are positive integers.

In an optional implementation solution, one or more elements among any four elements [$h_{ai},h_{bi},h_{bj},h_{aj}$] constituting a loop-4 in all basic parity check matrices of the basic parity check matrix set belong to elements of which column weights are 2, and satisfy an inequality $(h_{ai} - h_{bi} +h_{bj}-h_{aj})\%zf \neq 0$; and one or more elements among any six elements [$h_{ai},h_{bi},h_{bj},h_{cj},h_{ck},h_{ak}$] constituting a short loop-6 in all basic parity check matrices of the basic parity check matrix set belong to elements of which column weights are 2, and satisfy an inequality $(h_{ai} - h_{bi} +h_{bj}-h_{cj}+h_{ck}-h_{ak})\%zf \neq 0$.

In an optional implementation solution, the value of *ri* is [1/2, 5/8, 3/4, 13/16], i=0, 1, 2, 3, any four elements [$h_{ai},h_{bi},h_{bj},h_{aj}$] constituting a loop-4 in a basic parity check matrix Hb0 of which a corresponding code rate r0=1/2 all satisfy an inequality $(h_{ai}-h_{bi}+h_{bj}-h_{aj})\%zf \neq 0$; and any six elements ⌊$h_{ai},h_{bi},h_{bj},h_{cj},h_{ck},h_{ak}$⌋ constituting a short loop-6 in the basic parity check matrix Hb0 all satisfy an inequality $(h_{ai}-h_{bi}+h_{bj}-h_{cj}+h_{ck}-h_{ak})\%zf \neq 0$.

In an optional implementation solution, the step that the information bits to be encoded are encoded or the data to be decoded are decoded using the pre-set basic parity check matrix set *Hb* includes that: a block of the information bits to be encoded or a block of the data to be decoded is determined, a basic parity check matrix is selected from the basic parity check matrix set according to the block of the information bits to be encoded or the block of the data to be decoded, and the block of the information bits to be encoded are encoded or the block of the data to be decoded are decoded based on the selected basic parity check matrix.

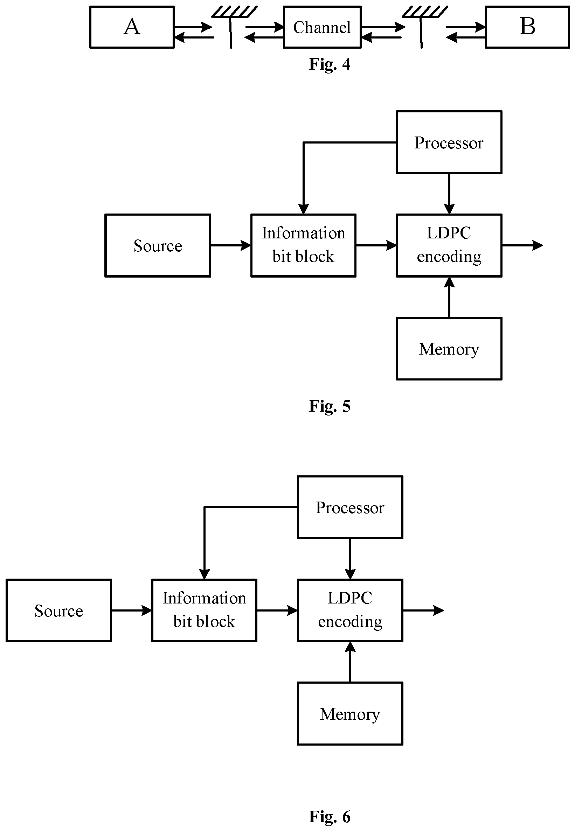

In order to further understand the solution provided by the embodiments of the present disclosure, the solution will be described below by taking a simple communication link model shown in Fig. 4 as an example.

Fig. 4 shows a simple communication link model. Information may be transmitted from an end A to an end B, or may be transmitted from the end B to the end A. The end A and the end B may be one or more types of devices such as a base station, a relay node, an access node and a terminal device, or a plurality of devices in the same device type. Data may be transmitted between the end A and the end B at any time, or data communication may be performed only when conditions allow. The apparatus for processing information provided by the embodiment of the present disclosure can be applied to any data transmission from the end A to the end B and from the end B to the end A.

In a communication link shown in Fig. 4, it can be seen that the end A may be equipped with t1 transmitting antennae and r1 receiving antennae, and the end B may also be equipped with t2 transmitting antennae and r2 receiving antennae. Generally, in the end A, $t1 \geq 1$, and $r1 \geq 1$; and in the end B, $t2 \geq 1$, and $r2 \geq 1$. The antennae of the end A may be fixed or movable; and meanwhile, the antennae of the end B may be fixed or movable.

In the communication link shown in Fig. 4, it is needed to perform communication transmission between the end A and the end B via a channel. The channel may be a wireless channel such as a microwave communication channel, an electromagnetic wave communication channel, a sound wave communication channel and an optical communication channel; the channel may also be a wired channel such as an optical fibre communication channel and a cable; or the channel may also be various storage media.

For simplicity, illustrations are made herein by taking sending of data information from a device a1 of the end A to a certain device b1 of the end B as an example. In this case, the a1 needs to read data from a source via a processor, form the data into a block, process (encode or modulate) the data block, and then transmit the data block via a transmitting antenna. A processor of the certain device b1 of the end B needs to receive a signal from a receiving antenna and process the signal to obtain original data. Conversely, a principle of data transmission from the end B to the end A is the same as the above.

In the above link communication or system communication, an LDPC code can be adopted to improve the reliability of data transmission. The LDPC code is a linear block code which can be defined by a very low density parity check matrix or a bipartite graph.

An encoder of the end A or the end B is shown in Fig. 5, and a decoder of the end A or the end B is shown in Fig. 6. Processors in the encoder/decoder are mainly responsible for various logical operations. As shown in Fig. 5, the processor in the encoder is mainly responsible for processing data, namely acquiring information to be sent from the source, forming information bits of the source into a block, performing LDPC encoding on an information bit block in cooperation with a memory, and then modulating and transmitting the information bit block. As shown in Fig. 6, the processor of the decoder acquires information from an antenna, configures a memory to perform LDPC decoding on the information, combines the information and then transmits the combined information to a destination. The memories of the encoder/decoder are mainly responsible for storing all pieces of data and program codes needed by the end A or the end B. That is, the memories are mainly responsible for storing information about a basic parity check matrix of the LDPC code and other pieces of data information.

As shown in Fig. 5, an LDPC encoder forms the information bits into one $1 \times k$ information bit block represented by "a" here. The information bit block a is encoded by means of the encoder to obtain a $1 \times n$ codeword bit block represented by "x" here. A basic matrix of the LDPC code is $Hb$, and a corresponding expansion check matrix is H.

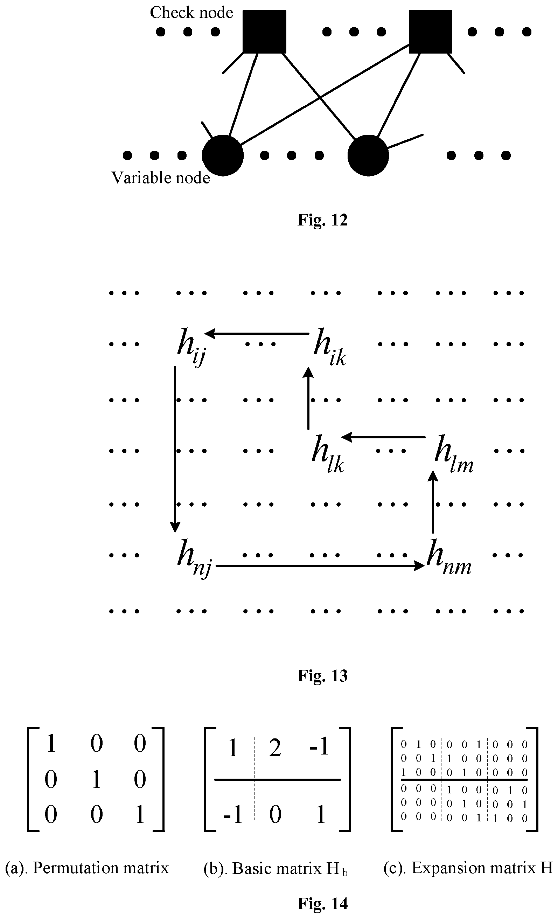

In this embodiment, the expansion check matrix H of the LDPC code is uniquely determined by the basic matrix $Hb$, an expansion factor $zf$ and a permutation matrix. The permutation matrix is generally a $zf \times zf$ unit matrix. If a certain element value $h_{ij}$ in the basic parity check matrix is equal to -1, the permutation matrix of this place is a $zf \times zf$ all-0 matrix, and if $h_{ij} \neq$ -1, the matrix of this place is a matrix obtained by rotate-right of the permutation matrix by $h_{ij}$. For example, in a specific example shown in Fig. 14, the expansion check matrix H of the LDPC code is determined by the basic matrix $Hb$ ($2\times3$), the expansion factor $zf$ (=3) and the permutation matrix ($3 \times 3$ unit matrix).

The LDPC code serves as a linear block code, the corresponding expansion check matrix is H, and the following relation can be satisfied for each codeword x:

$$H \times x^T = 0^T$$

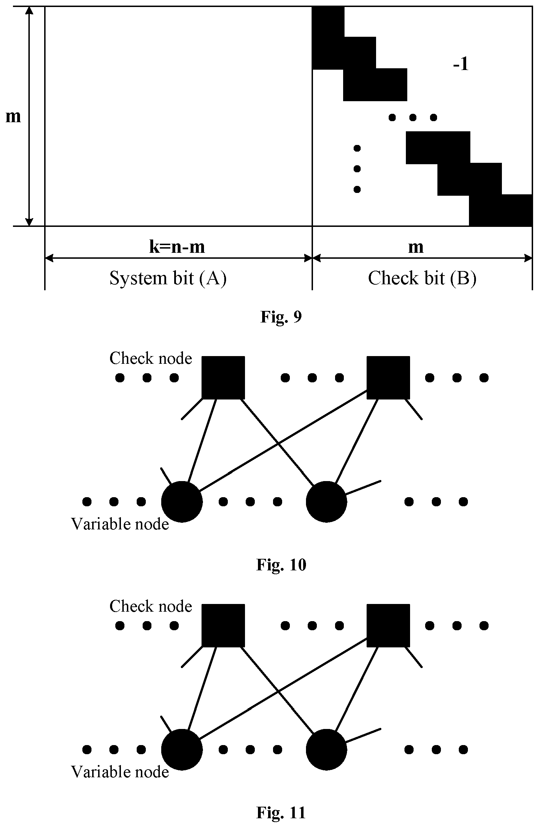

where '0' here is an all-0 vector. Since all operations are executed on a binary field, all addition and subtraction operations here are exclusive-or operations, and multiplication operations are AND operations. According to the relation, the expansion check matrix H can be divided into two parts: a system bit part matrix A and a check bit part matrix B, as shown in Fig. 9, that is,

$$H = [A\ B].$$

Meanwhile, an LDPC codeword x is divided into a system bit part vector a and a check bit part vector b as follows:

$$x = [a\ b].$$

The following relation can be obtained:

$$A \times a^T = B \times b^T$$

It can be seen that it is only needed to calculate a check part b. Since the matrix B can be specially processed and can be designed, for example, into a lower triangular structure or a double lower triangular structure, the check part b can be obtained by simple calculation. Then, an information part a and the check part b are combined, namely $c = [a\ b]$, to obtain the LDPC codeword x.

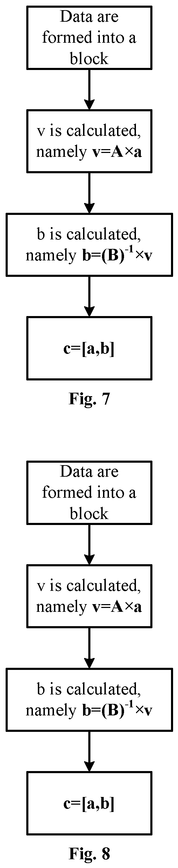

Fig. 7 shows a flowchart of LDPC encoding corresponding to an encoder. As shown in Fig. 7, LDPC encoding in the present embodiment mainly includes Step 1 to Step 4 as follows.

Step 1: Data to be encoded are formed into one $1 \times k$ information bit block namely a.

Step 2: v is calculated, namely $v = A \times a$.

Step 3: b is calculated, namely $b = (B)^{-1} \times a$, to obtain a check part.

Step 4: The information part a and the check part b are combined, namely $c = [a\ b]$, to obtain an LDPC codeword x.

In an LDPC decoder, two modules namely a processor (e.g., a Central Processing Unit (CPU)) and a memory are also needed. The processor is mainly responsible for various logical operations, and the memory is mainly responsible for storing information about a basic parity check matrix of an LDPC code and storing other pieces of decoded data information. The LDPC decoder is shown in Fig. 6.

There are multiple LDPC decoding methods such as a probability domain Belief Propagation (BP) decoding algorithm, a log domain BP decoding algorithm and a layered min-sum decoding algorithm. The performance of the probability domain BP decoding algorithm is optimal. But the probability domain BP decoding algorithm has the disadvantages that since a great amount of multiplication operations are involved and the operation burden are heavy, the needed hardware cost is very high, the dynamic range of a numerical value is large, and the stability is low. Thus, the probability domain BP decoding algorithm cannot be used in practical application generally. Compared with the probability domain BP decoding algorithm, the log domain BP decoding algorithm reduces many calculation units, but many multiplication operations are still needed, and therefore the needed hardware cost is not low. The layered min-sum decoding algorithm converts key calculation (log operation and multiplication operation) units of the log domain BP decoding algorithm into calculation of a minimum value and a secondary minimum value, and therefore the needed hardware resources are greatly reduced. Although there is a little loss in performance, many hardware resources can be reduced. Thus, the layered min-sum decoding algorithm is more frequently adopted in practical application.

For any decoding methods, it is needed to perform iterative decoding. A decoding module is mainly divided into two parts: a check node updating module and a variable node updating module. The LDPC decoder is shown in Fig. 6, and a corresponding flowchart for LDPC decoding is shown in Fig. 8. As shown in Fig. 8, LDPC decoding mainly includes Step 1 to Step 4 as follows.

Step 1: Initialization is performed.

Step 2: A check node is updated.

Step 3: A variable node is updated.

Step 4: An inequality $H \times s == 0 | Iter >$ max is judged, if so, the operation is ended, and otherwise, Step 2 is returned.

In LDPC encoding and decoding, whether or not characteristics such as excellent performance, high throughput, high flexibility and low complexity can be obtained is closely related to a designed LDPC code check matrix. Conversely, if the designed LDPC code check matrix is not appropriate enough, the performance of the LDPC encoding and decoding will be reduced, and meanwhile, the complexity and the flexibility may be influenced. Thus, how to obtain an appropriate LDPC code check matrix is very important.

In order to better understand the idea of the embodiments of the present disclosure, the situation of the constitution of girth by, e.g., short loops-4 and short loops-6, in a basic parity check matrix of an LDPC code will be introduced below.

In the basic parity check matrix, the necessary and sufficient conditions for the existence of girth=4 in a short loop-4 are that: in a basic matrix, any four elements $[h_{ai}, h_{bi}, h_{bj}, h_{aj}]$ which are able to constitute a loop-4 satisfy:

$$(h_{ai} - h_{bi} + h_{bj} - h_{aj})\%zf == 0 ,$$

where $zf$ is an expansion factor, the situation of girth=4 will occur between the elements at the four positions, and expressions in a bipartite graph are shown in Fig. 10. Thus, since information is only exchanged and transferred between these four nodes (two variable nodes and two check nodes), after multiple iterations are performed, the final codeword performance will be reduced due to the fact that most pieces of continuously exchanged information come from information fed back by themselves and there is not enough external information. Expressions of these elements in the basic parity check matrix are shown in Fig. 12 specifically, and expressions in the bipartite graph are shown in Fig. 10. Consequently, when the basic parity check matrix of the LDPC code is designed, it is needed to make the above equality false, that is,

$$(h_{ai} - h_{bi} + h_{bj} - h_{aj})\%zf \neq 0$$

In the basic parity check matrix, the necessary and sufficient conditions for the existence of girth=6 in a short loop-6 are that: in a basic matrix, any six elements ⌊$h_{ai},h_{bi},h_{bj},h_{cj},h_{ck},h_{ak}$⌋ which are able to constitute a loop-6 satisfy:

$$(h_{ai} - h_{bi} + h_{bj} - h_{cj} + h_{ck} - h_{ak})\%zf = 0 \,,$$

where *zf* is an expansion factor, the situation of girth=6 will occur between the elements at the six positions, and expressions in a bipartite graph are shown in Fig. 9. Thus, due to the same reason as girth=4, since most pieces of information are exchanged and transferred between these six nodes (three variable nodes and three check nodes), there is not enough external information exchanged, and the final codeword performance will be reduced (which is better than that in the short loops-4 to some extent). Expressions of these elements in the basic parity check matrix are shown in Fig. 13 specifically, and expressions in the bipartite graph are shown in Fig. 11. Consequently, when the basic parity check matrix of the LDPC code is designed, it is needed to make the above equality false (or occur as infrequently as possible), that is,

$$(h_{ai} - h_{bi} + h_{bj} - h_{cj} + h_{ck} - h_{ak})\%zf \neq 0$$

In accordance with a construction method for a basic parity check matrix of an LDPC code having multiple code rates provided by the embodiments of the present disclosure, analysis is performed below by means of a specific embodiment. Two parts, namely a processor and a memory, are contained in the specific embodiment of the encoder/decoder. The processor is mainly responsible for various logical operations, and the memory is mainly responsible for storing various pieces of information, in particular, very important basic parity check matrices in LDPC encoding and decoding.

In the specific embodiment, the code rates are respectively $R_0=1/2$, $R_1=5/8$, $R_2=3/4$ and $R_3=13/16$, corresponding basic parity check matrices are respectively $Hb_0$, $Hb_1$, $Hb_2$ and $Hb_3$, and the number of columns is 16. The number of rows of the basic parity check matrix corresponding to respective code rates is $(h_{ai}-h_{bi}+h_{bj}-h_{cj}+h_{ck}-h_{ak})\%zf \neq 0$ According to the above inventive content, these four basic parity check matrices are provided herein, an expansion factor *zf* is equal to 256, and a basic row weight is 4.

Basic parity check matrix $Hb_0$ corresponding to code rate $R_0=13/16$:

|   | 0 | 1 | 2 | 3 | 4 | 5 | 6 | 7 | 8 | 9 | 10 | 11 | 12 | 13 | 14 | 15 |
|---|----|----|----|----|----|----|----|----|----|----|----|----|----|----|----|----|
| 0 | 43 | 141 | 79 | 205 | 74 | 246 | 107 | 85 | 136 | 232 | 38 | 198 | 69 | 163 | -1 | -1 |
| 1 | 26 | 105 | 137 | 72 | 159 | 32 | 172 | 122 | 224 | 187 | 39 | 51 | 76 | 219 | 239 | -1 |
| 2 | 110 | 4 | 77 | 11 | 157 | 107 | 123 | 162 | 240 | 89 | 196 | 211 | 175 | 117 | 225 | 0 |

Basic parity check matrix $Hb_1$ corresponding to code rate $R_1=3/4$:

|   | 0 | 1 | 2 | 3 | 4 | 5 | 6 | 7 | 8 | 9 | 10 | 11 | 12 | 13 | 14 | 15 |
|---|----|----|----|----|----|----|----|----|----|----|----|----|----|----|----|----|
| 0 | 171 | 132 | 175 | 50 | 205 | 166 | 28 | 166 | 23 | 2 | 42 | 155 | 242 | -1 | -1 | -1 |
| 1 | 43 | 141 | 79 | 205 | 74 | 246 | 107 | 85 | 136 | 232 | 38 | 198 | 69 | 163 | -1 | -1 |
| 2 | 26 | 105 | 137 | 72 | 159 | 32 | 172 | 122 | 224 | 187 | 39 | 51 | 76 | 219 | 239 | -1 |
| 3 | 110 | 4 | 77 | 11 | 157 | 107 | 123 | 162 | 240 | 89 | 196 | 211 | 175 | 117 | 225 | 0 |

Basic parity check matrix $Hb_2$ corresponding to code rate $R_2=5/8$:

|   | 0 | 1 | 2 | 3 | 4 | 5 | 6 | 7 | 8 | 9 | 10 | 11 | 12 | 13 | 14 | 15 |
|---|----|----|----|----|----|----|----|----|----|----|----|----|----|----|----|----|
| 0 | -1 | -1 | 175 | 50 | -1 | 166 | 28 | -1 | 23 | 2 | 42 | -1 | -1 | -1 | -1 | -1 |
| 1 | 171 | 132 | -1 | 205 | 205 | -1 | 107 | 166 | -1 | -1 | -1 | 155 | -1 | -1 | -1 | -1 |

(continued)

|   | 0 | 1 | 2 | 3 | 4 | 5 | 6 | 7 | 8 | 9 | 10 | 11 | 12 | 13 | 14 | 15 |
|---|---|---|---|---|---|---|---|---|---|---|----|----|----|----|----|----|
| 2 | 43 | 141 | 79 | -1 | 74 | 246 | -1 | 85 | 136 | 232 | -1 | 198 | 242 | -1 | -1 | -1 |
| 3 | -1 | -1 | 137 | 72 | -1 | 32 | 172 | -1 | 224 | 187 | 38 | -1 | 69 | 163 | -1 | -1 |
| 4 | 26 | 105 | -1 | 11 | 159 | -1 | -1 | 122 | -1 | 89 | 39 | 51 | 76 | 219 | 239 | -1 |
| 5 | 110 | 4 | 77 | -1 | 157 | 107 | 123 | 162 | 240 | -1 | 196 | 211 | 175 | 117 | 225 | 0 |

Basic parity check matrix Hb$_3$ corresponding to code rate R$_3$=1/2:

|   | 0 | 1 | 2 | 3 | 4 | 5 | 6 | 7 | 8 | 9 | 10 | 11 | 12 | 13 | 14 | 15 |
|---|---|---|---|---|---|---|---|---|---|---|----|----|----|----|----|----|
| 0 | 171 | -1 | 175 | -1 | 205 | -1 | 28 | -1 | 23 | -1 | -1 | -1 | -1 | -1 | -1 | -1 |
| 1 | 43 | -1 | 79 | -1 | 74 | -1 | 107 | -1 | 136 | 0 | -1 | -1 | -1 | -1 | -1 | -1 |
| 2 | -1 | 132 | -1 | 50 | -1 | 166 | -1 | 166 | -1 | 2 | 42 | -1 | -1 | -1 | -1 | -1 |
| 3 | -1 | 141 | -1 | 205 | -1 | 246 | -1 | 85 | -1 | 232 | 38 | 155 | -1 | -1 | -1 | -1 |
| 4 | 26 | -1 | 137 | -1 | 159 | -1 | 172 | -1 | 224 | -1 | 39 | 198 | 242 | -1 | -1 | -1 |
| 5 | 110 | -1 | 77 | -1 | 157 | -1 | 123 | -1 | 240 | -1 | 196 | -1 | 69 | 163 | -1 | -1 |
| 6 | -1 | 105 | -1 | 72 | -1 | 32 | -1 | 122 | -1 | 187 | -1 | 51 | 76 | 219 | 239 | -1 |
| 7 | -1 | 4 | -1 | 11 | -1 | 107 | -1 | 162 | -1 | 89 | -1 | 211 | 175 | 117 | 225 | 0 |

From all the above basic parity check matrices, it can be seen that the basic parity check matrices have characteristics as follows.

(1) From the check matrix, provided above, for all code rates, it can be seen that the numbers of columns of all basic parity check matrices are identical to 16, and corresponding check bit part matrices are strictly lower triangular structures.

(2) A maximum column weight *MaxW* is 4, and sets constituted by non-minus-one elements on the same column in other basic parity check matrices of which the number of matrix rows is greater than or equal to the maximum column weight 4 are equal.

(3) The maximum column weight *MaxW* is 4, and the number of rows of a basic parity check matrix Hb1 corresponding to a code rate R1=3/4 is equal to 4, so that the number of matrix rows of the other basic parity check matrice of which the number of matrix rows is smaller than the maximum column weight 4, such as a basic parity check matrix Hb0 corresponding to a code rate R0=13/16, is 3, and the basic parity check matrix is equal to a matrix constituted by last three rows of the Hb$_1$.

(4) In a system bit part matrix of the same basic parity check matrix, the number of minus-one elements on different rows is equal, such as the Hb0 and the Hb1; or, a maximum difference value is smaller than or equal to 2, such as Hb2 and Hb3,.

(5) More than two or three continuous minus-one elements do not exist on the same row in the system bit part matrix of the same basic parity check matrix.

(6) More than two or three continuous minus-one elements do not exist on the same column in the system bit part matrix of the same basic parity check matrix.

(7) From the check matrix, provided above, for all code rates, it can be seen that more than 50 percent of all short loops-4 constituted in each of other basic parity check matrices, except the $Hb_{j1}$, are the same as short loops-4 constituted in the $Hb_{j1}$.

(8) In the basic parity check matrix, any four elements [$h_{ac}$,$h_{bc}$,$h_{bd}$,$h_{ad}$] which are able to constitute short loops-4 all satisfy an inequality ($h_{ac}$-$h_{bc}$+$h_{bd}$-$h_{ad}$)%zf ≠ 0, where % is a modulo operator, zf is an expansion factor, and zf =256.

(9) In the basic parity check matrix, any six elements ⌊$h_{ai}$,$h_{bi}$,$h_{bj}$,$h_{cj}$,$h_{ck}$,$h_{ak}$⌋ which are able to constitute short loops-6 all satisfy an inequality ($h_{ai}$-$h_{bi}$+$h_{bj}$-$h_{cj}$+$h_{ck}$-$h_{ak}$)%zf ≠ 0, or the number of short loops-6 satisfying the inequality is maximum, where % is a modulo operator, zf is an expansion factor, and zf =256.

From the above descriptions, by means of the technical solutions provided by the embodiments of the present disclosure, basic parity check matrices for all code rates are correlated, and the following benefits are achieved.

(1) The basic parity check matrices for all code rates can keep matrix short-loop characteristics consistent substantially. Thus, when the performance of one basic parity check matrix (in the present embodiment, a code rate is

$R_1$=3/4) is quite excellent, it can be ensured that the performances of basic parity check matrices for other code rates will be good.

(2) The forms of the basic parity check matrices for all code rates are consistent substantially, so that the same decoder can be completely shared. Thus, hardware resources can be greatly reduced. It is unnecessary to waste a great number of resources to make a decoder for each code rate (check matrix) or it is unnecessary to greatly adjust a decoder to support other code rates.

Obviously, those skilled in the art shall understand that all modules or all steps in the present disclosure can be implemented by using a general calculation apparatus, can be centralized on a single calculation apparatus or can be distributed on a network composed of a plurality of calculation apparatuses. Optionally, they can be implemented by using executable program codes of the calculation apparatuses. Thus, they can be stored in a storage apparatus and executed by the calculation apparatuses, the shown or described steps can be executed in a sequence different from this sequence under certain conditions, or they are manufactured into each integrated circuit module respectively, or a plurality of modules or steps therein are manufactured into a single integrated circuit module. Thus, the present disclosure is not limited to a combination of any specific hardware and software.

The above is only the preferred embodiments of the present disclosure, and is not intended to limit the present disclosure. There can be various modifications and variations in the present disclosure for those skilled in the art. Any modifications, equivalent replacements, improvements and the like within the principle of the present disclosure shall fall within the protection scope defined by the appended claims of the present disclosure.

## Industrial Applicability

In the embodiments of the present disclosure, when LDPC encoding/decoding operation is adopted, a plurality of check matrices corresponding to a plurality of code rates are associated, so that encoding or decoding operation can be performed using the same encoder or decoder, the problems of high hardware complexity and low flexibility are solved, the hardware complexity is reduced, and the flexibility in encoding/decoding operation is improved. The embodiments of the present disclosure have industrial practicality.

## Claims

1. An apparatus for processing information, comprising:

   one or more memories, configured to store parameters of one basic parity check matrix set; and
   one or more processors, configured to encode information bits to be encoded or decode data to be decoded using the basic parity check matrix set $Hb$ , wherein at least 50 percent of short loops-4 in a basic parity check matrix $Hb_{j1}$ among all basic parity check matrices in the basic parity check matrix set $Hb$ except $Hb_{j0}$ are the same as short loops-4 in the $Hb_{j0}$, where j0 is a fixed positive integer between 0 and L-1, L is the number of basic parity check matrices contained in the basic parity check matrix set, and $j1 = 0,1,..., j0$ -1, $j0 + 1,..., L$ -1.

2. The apparatus as claimed in claim 1, wherein a dimension of each basic parity check matrix in the basic parity check matrix set is $Mb \times Nb,$ the number of columns $Nb$ is a fixed value $nb0,$ the number of rows $Mb$ is $mbi$ , and each $mbi$ corresponds to one code rate $ri$ , where $ri$ is a real number between 0 and 1, $i = 0,1,2,......, L$ -1, $mbi$ is an integer greater than 0, and $nb0$ is an integer greater than 0.

3. The apparatus as claimed in claim 2, wherein each of the short loops-4 is constituted by four non-minus-one elements $[h_{ac}, h_{bc}, h_{bd}, h_{ad}]$ obtained by intersecting a $c^{th}$ column and a $d^{th}$ column with an $a^{th}$ row and a $b^{th}$ row in the basic parity check matrix, where a, b, c and d are any integers which are greater than or equal to 0 and are smaller than $nb0,$ c<d, and a<b.

4. The apparatus as claimed in claim 2, wherein a set $Scj1$ constituted by non-minus-one elements in a $c^{th}$ column of the basic parity check matrix $Hb_{j1}$, among all the basic parity check matrices in the basic parity check matrix set except the $Hb_{j0}$, from top to bottom is a subset of a set $Scj0$ constituted by non-minus-one elements in a $c^{th}$ column of the $Hb_{j0}$ from top to bottom, where the $Hb_{j0}$ is a basic parity check matrix of which the number of matrix rows is equal to a maximum column weight $MaxW$ , the maximum column weight $MaxW$ refers to a column weight of a column with maximum weight among all columns of all basic parity check matrices in the basic parity check matrix set, $MaxW$ is a positive integer, and c is an integer which is greater than or equal to 0 and is smaller than $nb0.$

5. The apparatus as claimed in claim 4, wherein a top-to-bottom sequence of all elements in the set $Scj1$ is identical to a top-to-bottom sequence of these elements in the set $Scj0$.

6. The apparatus as claimed in claim 2, wherein each basic parity check matrix $Hbi$ in the basic parity check matrix set is equal to [$Abi\ Bbi$], where a matrix $Abi$ is a system bit part matrix with a dimension of $Mb\times(Nb - Mb)$, a matrix $Bbi$ is a check bit part matrix with a dimension of $Mb\times Mb$, the number of rows of the matrix $Abi$ is equal to the number of rows of the matrix $Bbi$, row weights of the matrices $Abi$ and $Bbi$ are greater than or equal to 1, and the matrix $Bbi$ is a strictly lower triangular structure matrix or a double diagonal structure matrix.

7. The apparatus as claimed in claim 6, wherein the number of minus-one elements on different rows of the system bit part matrix of each basic parity check matrix in the basic parity check matrix set is equal or has a difference smaller than or equal to 2.

8. The apparatus as claimed in claim 6, wherein more than two or three continuous minus-one elements do not exist on each column of the system bit part matrix of each basic parity check matrix in the basic parity check matrix set.

9. The apparatus as claimed in claim 6, wherein more than two or three continuous minus-one elements do not exist on each row of the system bit part matrix in the basic parity check matrix set.

10. The apparatus as claimed in any one of claims 2 to 9, wherein the value of $nb0$ comprises: 8, 16, 24, 32, 40 or 48.

11. The apparatus as claimed in claim 1, wherein the condition that the short loops-4 in the $Hb_{j1}$ are the same as the short loops-4 in the $Hb_{j0}$ comprises that:

   values of all corresponding elements of the short loops-4 in the $Hb_{j1}$ and the short loops-4 in the $Hb_{j0}$ are equal, two elements of each short loop-4 on a row of the $Hb_{j1}$ are equal to two elements of each short loop-4 on a row of the $Hb_{j0}$ in a one-to-one correspondence manner, and two elements of each short loop-4 on a column of the $Hb_{j1}$ are equal to two elements of each short loop-4 on a column of the $Hb_{j0}$ in a one-to-one correspondence manner.

12. The apparatus as claimed in claim 1, wherein any four elements [$h_{ac},h_{bc},h_{bd},h_{ad}$] which are able to constitute a loop-4 in each basic parity check matrix of the basic parity check matrix set satisfy an inequality $(h_{ac}\text{-}h_{bc}\text{+}h_{bd}\text{-}h_{ad})\%zf \neq 0$, where % is a modulo operator, $zf$ is an expansion factor, a, b, c and d are any integers which are greater than or equal to 0 and are smaller than $nb0$, $a \neq b$, and $c \neq d$.

13. The apparatus as claimed in claim 1, wherein the number of any six elements [$h_{ai},h_{bi},h_{bj},h_{cj},h_{ck},h_{ak}$] which are able to constitute a loop-6 in all basic parity check matrices of the basic parity check matrix set and satisfy an inequality $(h_{ai} - h_{bi} +h_{bj}\text{-}h_{cj}+ h_{ck} - h_{ak})\%zf ==0$ is minimum, where % is a modulo operator, $zf$ is an expansion factor, a, b, c, i, j and k are any integers which are greater than or equal to 0 and are smaller than $nb0$, $a \neq b \neq c$, and $i \neq j \neq k$.

14. The apparatus as claimed in claim 1, wherein a basic parity check matrix of which the number of matrix rows, j, is smaller than a maximum column weight $MaxW$ in the basic parity check matrix set is equal to a matrix constituted by last j rows of the $Hb_{j0}$, where the $Hb_{j0}$ is a basic parity check matrix of which the number of matrix rows is equal to the maximum column weight $MaxW$, and $MaxW$ and j are positive integers.

15. The apparatus as claimed in claim 1, wherein one or more elements among any four elements [$h_{ai},h_{bi},h_{bj},h_{aj}$] constituting a loop-4 in all basic parity check matrices of the basic parity check matrix set belong to elements of which column weights are 2, and satisfy an inequality $(h_{ai} - h_{bi} +h_{bj}\text{-}h_{aj})\%zf \neq 0$ ; and one or more elements among any six elements [$h_{ai},h_{bi},h_{bj},h_{cj},h_{ck},h_{ak}$] constituting a short loop-6 in all basic parity check matrices of the basic parity check matrix set belong to elements of which column weights are 2, and satisfy an inequality $(h_{ai}\text{-}h_{bi}+h_{bj}\text{-}h_{cj}+h_{ck} -h_{ak})\%zf \neq 0$, where % is a modulo operator, $zf$ is an expansion factor, a, b, c, i, j and k are any integers which are greater than or equal to 0 and are smaller than $nb0$, $a \neq b \neq c$, and $i \neq j \neq k$.

16. The apparatus as claimed in claim 2, wherein the value of $ri$ is [1/2, 5/8, 3/4, 13/16], i=0, 1, 2, 3, any four elements [$h_{ai},h_{bi},h_{bj},h_{aj}$] constituting a loop-4 in a basic parity check matrix Hb0 of which a corresponding code rate r0=1/2 all satisfy an inequality $(h_{ai}\text{-}h_{bi}+h_{bj}\text{-}h_{aj})\%zf \neq 0$; and any six elements $\llcorner h_{ai},h_{bi},h_{bj},h_{cj},h_{ck},h_{ak}\lrcorner$ constituting a short loop-6 in the basic parity check matrix Hb0 all satisfy an inequality $(h_{ai} - h_{bi} + h_{bj} -h_{cj} +h_{ck} -h_{ak})\%zf \neq 0$, where % is a modulo operator, $zf$ is an expansion factor, a, b, c, i, j and k are any integers which are greater than or equal to 0 and are

EP 3 107 214 A1

smaller than $nb0$, $a \neq b \neq c$, and $i \neq j \neq k$.

17. The apparatus as claimed in claim 1, wherein the one or more processors encode the information bits to be encoded or decode the data to be decoded by means of the following modes: determining a block of the information bits to be encoded or a block of the data to be decoded, selecting a basic parity check matrix from the basic parity check matrix set according to the block of the information bits to be encoded or the block of the data to be decoded, and encoding the block of the information bits to be encoded or decoding the block of the data to be decoded based on the selected basic parity check matrix.

18. A method for processing information, comprising:

acquiring information bits to be encoded or data to be decoded; and
encoding the information bits to be encoded or decoding the data to be decoded using a pre-set basic parity check matrix set $Hb$ , wherein at least 50 percent of short loops-4 in a basic parity check matrix $Hb_{j1}$, among all basic parity check matrices in the basic parity check matrix set $Hb$ except $Hb_{j0}$ are the same as short loops-4 in the $Hb_{j0}$, where j0 is a fixed positive integer between 0 and L-1, L is the number of basic parity check matrices contained in the basic parity check matrix set, and $j1 = 0,1,..., j0 -1, j0 + 1,..., L$ -1.

19. The method as claimed in claim 18, wherein a dimension of each basic parity check matrix in the basic parity check matrix set is $Mb \times Nb,$ the number of columns $Nb$ is a fixed value $nb0$, the number of rows $Mb$ is $mbi$ , and each $mbi$ corresponds to one code rate $ri$ , where $ri$ is a real number greater than 0, $i = 0,1,2,......, L$ -1, $mbi$ is an integer greater than 0, and $nb0$ is an integer greater than 0.

20. The method as claimed in claim 19, wherein each of the short loops-4 is constituted by four non-minus-one elements $[h_{ac},h_{bc},h_{bd},h_{ad}]$ obtained by intersecting a $c^{th}$ column and a $d^{th}$ column with an $a^{th}$ row and a $b^{th}$ row in the basic parity check matrix, where a, b, c and d are any integers which are greater than or equal to 0 and are smaller than $nb0,$ c<d, and a<b.

21. The method as claimed in claim 19, wherein a set $Scj1$ constituted by non-minus-one elements in a $c^{th}$ column in the basic parity check matrix $Hb_{j1}$, among all the basic parity check matrices in the basic parity check matrix set except the $Hb_{j0}$, from top to bottom is a subset of a set $Scj0$ constituted by non-minus-one elements in a $c^{th}$ column of the $Hb_{j0}$ from top to bottom, where the $Hb_{j0}$ is a basic parity check matrix of which the number of matrix rows is equal to a maximum column weight $MaxW$ , the maximum column weight $MaxW$ refers to a column weight of a column with maximum weight among all columns of all basic parity check matrices in the basic parity check matrix set, $MaxW$ is a positive integer, and c is an integer which is greater than or equal to 0 and is smaller than $nb0.$

22. The method as claimed in claim 21, wherein a top-to-bottom sequence of all elements in the set $Scj1$ is identical to a top-to-bottom sequence of these elements in the set $Scj0$.

23. The method as claimed in claim 19, wherein each basic parity check matrix $Hbi$ in the basic parity check matrix set is equal to $[Abi \ Bbi]$, where a matrix $Abi$ is a system bit part matrix with a dimension of $Mb\times (Nb$ -$Mb),$ a matrix $Bbi$ is a check bit part matrix with a dimension of $Mb\times Mb,$ the number of rows of the matrix $Abi$ is equal to the number of rows of the matrix $Bbi,$ row weights of the matrices $Abi$ and $Bbi$ are greater than or equal to 1, and the matrix $Bbi$ is a strictly lower triangular structure matrix or a double diagonal structure matrix.

24. The method as claimed in claim 23, wherein the number of minus-one elements on different rows of the system bit part matrix of each basic parity check matrix in the basic parity check matrix set is equal or has a difference smaller than or equal to 2.

25. The method as claimed in claim 23, wherein more than two or three continuous minus-one elements do not exist on each column of the system bit part matrix of each basic parity check matrix in the basic parity check matrix set.

26. The method as claimed in claim 23, wherein more than two or three continuous minus-one elements do not exist on each row of the system bit part matrix in the basic parity check matrix set.

27. The method as claimed in any one of claims 19 to 26, wherein the value of $nb0$ comprises: 8, 16, 24, 32, 40 or 48.

28. The method as claimed in claim 18, wherein the condition that the short loops-4 in the $Hb_{j1}$, are the same as the short loops-4 in the $Hb_{j0}$ comprises that:

values of all corresponding elements of the short loops-4 in the $Hb_{j1}$ and the short loops-4 in the $Hb_{j0}$ are equal, two elements of each short loop-4 on a row of the $Hb_{j1}$, are equal to two elements of each short loop-4 on a row of the $Hb_{j0}$ in a one-to-one correspondence manner, and two elements of each short loop-4 on a column of the $Hb_{j1}$, are equal to two elements of each short loop-4 on a column of the $Hb_{j0}$ in a one-to-one correspondence manner.

29. The method as claimed in claim 18, wherein any four elements $[h_{ac},h_{bc},h_{bd},h_{ad}]$ which are able to constitute a loop-4 in each basic parity check matrix of the basic parity check matrix set satisfy an inequality $(h_{ac}-h_{bc}+h_{bd}-h_{ad})\%zf \neq 0$, where % is a modulo operator, zf is an expansion factor, a, b, c and d are any integers which are greater than or equal to 0 and are smaller than $nb0$, $a \neq b$, and $c \neq d$.

30. The method as claimed in claim 18, wherein the number of any six elements $[h_{ai},h_{bi},h_{bj},h_{cj},h_{ck},h_{ak}]$ which are able to constitute a loop-6 in all basic parity check matrices of the basic parity check matrix set and satisfy an inequality $(h_{ai} - h_{bi} + h_{bj} - h_{cj} + h_{ck} - h_{ak})\%zf == 0$ is minimum, where % is a modulo operator, zf is an expansion factor, a, b, c, i, j and k are any integers which are greater than or equal to 0 and are smaller than $nb0$, $a \neq b \neq c$, and $i \neq j \neq k$.

31. The method as claimed in claim 18, wherein a basic parity check matrix of which the number of matrix rows, j, is smaller than a maximum column weight $MaxW$ in the basic parity check matrix set is equal to a matrix constituted by last j rows of the $Hb_{j0}$, where the $Hb_{j0}$ is a basic parity check matrix of which the number of matrix rows is equal to the maximum column weight $MaxW$, and $MaxW$ and j are positive integers.

32. The method as claimed in claim 18, wherein one or more elements among any four elements $[h_{ai},h_{bi},h_{bj},h_{aj}]$ constituting a loop-4 in all basic parity check matrices of the basic parity check matrix set belong to elements of which column weights are 2, and satisfy an inequality $(h_{ai}-h_{bi}+h_{bj}-h_{aj})\%zf \neq 0$; and one or more elements among any six elements $\llcorner h_{ai},h_{bi},h_{bj},h_{cj},h_{ck},h_{ak}\lrcorner$ constituting a short loop-6 in all basic parity check matrices of the basic parity check matrix set belong to elements of which column weights are 2, and satisfy an inequality $(h_{ai} - h_{bi} + h_{bj} - h_{cj} + h_{ck} - h_{ak})\%zf \neq 0$, where % is a modulo operator, $zf$ is an expansion factor, a, b, c, i, j and k are any integers which are greater than or equal to 0 and are smaller than $nb0$, $a \neq b \neq c$, and $i \neq j \neq k$.

33. The method as claimed in claim 19, wherein the value of $ri$ is [1/2, 5/8, 3/4, 13/16], i=0, 1, 2, 3 , any four elements $[h_{ai},h_{bi},h_{bj},h_{aj}]$ constituting a loop-4 in a basic parity check matrix Hb0 of which a corresponding code rate r0=1/2 all satisfy an inequality $(h_{ai}-h_{bi}+h_{bj}-h_{aj})\%zf \neq 0$; and any six elements $\llcorner h_{ai},h_{bi},h_{bj},h_{cj},h_{ck},h_{ak}\lrcorner$ constituting a short loop-6 in the basic parity check matrix Hb0 all satisfy an inequality $(h_{ai} - h_{bi} + h_{bj} - h_{cj} + h_{ck} - h_{ak})\%zf \neq 0$, where % is a modulo operator, $zf$ is an expansion factor, a, b, c, i, j and k are any integers which are greater than or equal to 0 and are smaller than $nb0$, $a \neq b \neq c$, and $i \neq j \neq k$.

34. The method as claimed in claim 18, wherein encoding the information bits to be encoded or decoding the data to be decoded using the pre-set basic parity check matrix set $Hb$ comprises: determining a block of the information bits to be encoded or a block of the data to be decoded, selecting a basic parity check matrix from the basic parity check matrix set according to the block of the information bits to be encoded or the block of the data to be decoded, and encoding the block of the information bits to be encoded or decoding the block of the data to be decoded based on the selected basic parity check matrix.

Sending end

Noise

Receiving end

Source → Channel encoding → Modulation → Channel ← (Noise) → Demodulation → Channel decoding → Destination

**Fig. 1**

One or more memories
20

One or more processors
22

**Fig. 2**

Information bits to be encoded or data to be decoded are acquired — S302

The information bits to be encoded are encoded or the data to be decoded are decoded using a pre-set basic parity check matrix set — S304

**Fig. 3**

**Fig. 4**

**Fig. 5**

**Fig. 6**

Data are
formed into a
block

v is calculated,
namely $\mathbf{v=A\times a}$

b is calculated,
namely $\mathbf{b=(B)^{-1}\times v}$

$\mathbf{c=[a,b]}$

**Fig. 7**

Data are
formed into a
block

v is calculated,
namely $\mathbf{v=A\times a}$

b is calculated,
namely $\mathbf{b=(B)^{-1}\times v}$

$\mathbf{c=[a,b]}$

**Fig. 8**

Fig. 9

Fig. 10

Fig. 11

**Fig. 12**

**Fig. 13**

$$\begin{bmatrix} 1 & 0 & 0 \\ 0 & 1 & 0 \\ 0 & 0 & 1 \end{bmatrix}$$

$$\begin{bmatrix} 1 & 2 & -1 \\ \hline -1 & 0 & 1 \end{bmatrix}$$

$$\begin{bmatrix} 0 & 1 & 0 & 0 & 0 & 1 & 0 & 0 & 0 \\ 0 & 0 & 1 & 1 & 0 & 0 & 0 & 0 & 0 \\ 1 & 0 & 0 & 0 & 1 & 0 & 0 & 0 & 0 \\ 0 & 0 & 0 & 1 & 0 & 0 & 0 & 1 & 0 \\ 0 & 0 & 0 & 0 & 1 & 0 & 0 & 0 & 1 \\ 0 & 0 & 0 & 0 & 0 & 1 & 1 & 0 & 0 \end{bmatrix}$$

(a). Permutation matrix     (b). Basic matrix H b     (c). Expansion matrix H

**Fig. 14**

<div align="center">**INTERNATIONAL SEARCH REPORT**</div>

| International application No. |
|---|
| **PCT/CN2014/085949** |

**A.  CLASSIFICATION OF SUBJECT MATTER**

<div align="center">H03M 13/11 (2006.01) i</div>

According to International Patent Classification (IPC) or to both national classification and IPC

**B.  FIELDS SEARCHED**

Minimum documentation searched (classification system followed by classification symbols)

<div align="center">H03M; H04Q; H04W</div>

Documentation searched other than minimum documentation to the extent that such documents are included in the fields searched

Electronic data base consulted during the international search (name of data base and, where practicable, search terms used)

CNKI, CNPAT, EPODOC, WPI: odd-even check, four-loop, six-loop, LDPC, sparse matrix, channel code, code, decode, low density, odd-even, verity, matrix, loop, expand, sparse

**C.  DOCUMENTS CONSIDERED TO BE RELEVANT**

| Category* | Citation of document, with indication, where appropriate, of the relevant passages | Relevant to claim No. |
|---|---|---|
| A | CN 102412842 A (ZTE CORP.), 11 April 2012 (11.04.2012), the whole document | 1-34 |
| A | WO 2009060627 A1 (PANASONIC CORPORATION), 14 May 2009 (14.05.2009), the whole document | 1-34 |
| A | US 2011289375 A1 (PANASONIC CORPORATION), 24 November 2011 (24.11.2011), the whole document | 1-34 |
| A | CN 101162907 A (HUAWEI TECHNOLOGIES CO., LTD.), 16 April 2008 (16.04.2008), the whole document | 1-34 |

☐ Further documents are listed in the continuation of Box C.        ☒  See patent family annex.

| \* | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 November 2014 (15.11.2014) | **28 November 2014 (28.11.2014)** |

| Name and mailing address of the ISA/CN:<br>State Intellectual Property Office of the P. R. China<br>No. 6, Xitucheng Road, Jimenqiao<br>Haidian District, Beijing 100088, China<br>Facsimile No.: (86-10) 62019451 | Authorized officer<br><br>**WANG, Xinyue**<br><br>Telephone No.: (86-10) **82245268** |

Form PCT/ISA/210 (second sheet) (July 2009)

## INTERNATIONAL SEARCH REPORT
Information on patent family members

International application No.

**PCT/CN2014/085949**

| Patent Documents referred in the Report | Publication Date | Patent Family | Publication Date |
|---|---|---|---|
| CN 102412842 A | 11 April 2012 | WO 2012037749 A1 | 29 March 2013 |
| WO 2009060627 A1 | 14 May 2009 | CN 101431337 A | 13 May 2009 |
| | | US 2010251062 A1 | 30 September 2009 |
| US 2011289375 A1 | 24 November 2011 | WO 2010035501 A1 | 01 April 2010 |
| | | CN 101686061 A | 31 March 2010 |
| | | CN 102165700 A | 24 August 2011 |
| CN 101162907 A | 16 April 2008 | None | |

Form PCT/ISA/210 (patent family annex) (July 2009)